# EUROPÄISCHE PATENTSCHRIFT

(11) **EP 3 298 363 B1**
(45) Veröffentlichungstag und Bekanntmachung des Hinweises auf die Patenterteilung: **10.06.2020**
(21) Anmeldenummer: 16715457.4
(22) Anmeldetag: 09.04.2016
(51) Int. Cl.: G01G 21/28, G01S 17/02

(54) **WÄGEVORRICHTUNG MIT NÄHERUNGSSENSOR**
WEIGHING DEVICE WITH PROXIMITY SENSOR
BALANCE AVEC CAPTEUR DE PROXIMITÉ

(30) Priorität: 22.05.2015 DE 102015108102
(43) Veröffentlichungstag der Anmeldung: 28.03.2018
(73) Patentinhaber: Sartorius Lab Instruments GmbH & Co. KG, 37079 Göttingen (DE)
(72) Erfinder: FELDOTTE, Heinrich, 37079 Göttingen (DE); JÜNEMANN, Manuel, 37191 Katlenburg-Lindau (DE); STÄNDER, Malte, 37308 Heiligenstadt (DE)
(74) Vertreter: Vigand, Philippe
(86) Internationale Anmeldenummer: PCT/EP2016/000588
(87) Internationale Veröffentlichungsnummer: WO 2016/188601

(56) Entgegenhaltungen:
- WO-A1-01/54277
- WO-A1-2009/006306
- DE-U1- 20 316 286
- US-A1- 2008 239 325

## Beschreibung

### Gebiet der Erfindung

Die Anmeldung betrifft eine Wägevorrichtung, umfassend
- eine Wägegutaufnahme,
- ein die Wägegutaufnahme umgebendes Schutzgehäuse mit einer Zugangsöffnung und einem die Zugangsöffnung in seiner Verschlussstellung verschließenden und sie in seiner Offenstellung freigebenden Verschlusselement,
- einen Reflexionssensor mit einem Strahlungssender zur Aussendung einer von einem Reflexionsobjekt reflektierbaren Sensorstrahlung und mit einem Strahlungsempfänger zum Empfangen eines von dem Reflexionsobjekt reflektierten Sensorstrahlungsanteils und
- eine mit einem motorischen Antrieb des Verschlusselementes und mit dem Reflexionssensor verbundene Steuereinheit, die eingerichtet ist, den motorischen Antrieb in Abhängigkeit von einem Signal des Reflexionssensors zur Überführung des Verschlusselementes zwischen seiner Verschluss- und seiner Offenstellung anzusteuern.

### Stand der Technik

Derartige Wägevorrichtungen sind bekannt aus der EP 0 216 035 A2.

Wägevorrichtungen, insbesondere elektronische Wägevorrichtungen, finden Anwendung in unterschiedlichsten Gebieten. Ein wichtiges Anwendungsfeld ist die sogenannte Pipettenkalibrierung. Bei der Pipettenkalibrierung wird ein Probengefäß auf der Wägegutaufnahme einer Wägevorrichtung positioniert und schrittweise mittels einer Pipette befüllt, wobei die Füllmenge jedes Befüllschrittes gravimetrisch gemessen und mit den entsprechenden Nominalwerten der Pipette verglichen wird, sodass die Genauigkeit der Pipette überprüft bzw. eingestellt werden kann. Zum Befüllen des Probengefäßes ist es zwingend notwendig, dass die Pipette wenigstens bereichsweise in den Wägeraum eindringt. Andererseits ist es notwendig, den Wägeraum vor externen Störeinflüssen zu schützen. Insbesondere können Luftströmungen und Temperaturschwankungen das Wägeergebnis verfälschen. Diese von herkömmlichen elektronischen Waagen her bekannte Problematik wird üblicherweise mit einem geschlossenen sog. Windschutz, einem Wägeraumboden und einem Wägeraumdeckel gelöst, d.h. mit einem den Wägeraum vollumfänglich umgebenden Schutzgehäuse. Zur Positionierung und Manipulation des Wägegutes ist es dabei auch bekannt, wenigstens eine Wand des Schutzgehäuses so zu gestalten, dass sie bedarfsweise geöffnet und geschlossen werden kann. Das Problem der Zugänglichkeit des Wägeraums verschärft sich bei Pipettenkalibrierstationen, d.h. bei für die Pipettenkalibrierung spezialisierten Wägevorrichtungen, dadurch, dass bei üblichen Pipettenkalibriervorgängen sehr viele Befüllvorgänge des Probengefäßes in sehr kurzer Zeit hintereinander durchgeführt werden müssen. Hierfür jeweils eine gesamte Wand, z.B. einen Abschnitt des Windschutzes, zu öffnen, wäre mit zu großen Störungen der Atmosphäre im Wägeraum verbunden.

In der EP 1 715 312 B1 wird vorgeschlagen, innerhalb einer Windschutzwand eine kleine Öffnung vorzusehen, die gerade hinreichend groß ist, um eine Pipette oder ein anderes Manipulationswerkzeug zu dem Probengefäß auf der Wägegutaufnahme führen zu können. Diese Öffnung ist bei der bekannten Vorrichtung mittels eines bewegbaren Verschlusselementes, welches die Form eines Schiebers, einer Klappe oder einer Iris haben kann, verschließbar bzw. zu öffnen. Die Druckschrift erwähnt beiläufig auch die Möglichkeit eines motorischen Antriebs des Verschlusselementes, womit implizit auch das Vorsehen einer Steuereinheit zur Ansteuerung des Motors offenbart wird. Problematisch ist jedoch die für die Bedienperson lästige Befehlsgabe zum Öffnen bzw. Schließen des Verschlusselementes bei jedem Pipettiervorgang.

Aus der DE 203 16 286 U1 ist bekannt, hierfür einen berührungslosen Schalter in Form einer Lichtschranke vorzusehen. Dies hat jedoch den Nachteil, dass die Bedienperson gezwungen ist, beim Pipettieren stets denselben Bewegungsablauf, nämlich insbesondere das Passieren der Lichtschranke, zu vollführen. Das kann bei umfangreichen Pipettiervorgängen ergonomisch belastend werden.

Aus der DE 203 04 465 U1 ist eine Analysenwaage bekannt, die über einen Windschutz mit motorisch angetriebenen Wandelementen verfügt, wobei der Motor über eine Antenne zum Abfragen eines Transponders ansteuerbar ist. Hierbei ist es erforderlich, dass die entsprechenden Transponder an den zu wägenden Proben oder Probenbehältern befestigt sind.

Die oben genannte, gattungsbildende Druckschrift sieht daher vor, einen Reflexionssensor, z.B. einen Infrarot- oder Ultraschallsensor, mit definiert begrenztem Empfindlichkeitsbereich zu verwenden und derart mit der Steuereinrichtung zu koppeln, dass ein Eintreten eines Gegenstandes, z.B. der Pipettenspitze, in den Empfindlichkeitsbereich ein Öffnen und ein Herausnehmen des Gegenstandes aus dem Empfindlichkeitsbereich ein Schließen des Verschlusselementes bewirkt. Weil die Reflexionseigenschaften unterschiedlicher Gegenstände an sich und auch in Abhängigkeit von ihrer Ausrichtung und Bewegung unterschiedlich sind, ist der für das Schließen bzw. Öffnen relevante Empfindlichkeitsbereich des Sensors nicht klar definiert. Dies kann zu fehlerhafter Betätigung des Verschlusselementes führen. Das Bedienpersonal muss mit einigem Lernaufwand ein Gefühl dafür entwickeln, welche Bewegungen durchgeführt werden können, ohne dass der Sensor aktiviert wird, bzw. welche Bewegungen durchgeführt werden müssen, damit der Sensor aktiviert wird. Allerdings werden die möglichen bzw. nötigen Bewegungen und Körperhaltungen nicht von allen Bedienpersonen und nicht über lange Zeiträume als ergonomisch angenehm empfunden. Zusätzlich kann sich die Erstreckung des Empfindlichkeitsbereichs auch durch Alterung oder Verschmutzung von Sensorkomponenten ändern.

### Aufgabenstellung

Es ist die Aufgabe der vorliegenden Erfindung, eine gattungsgemäße Wägevorrichtung derart weiterzubilden, dass die Betätigung des Verschlusselementes besser an die individuellen Bewegungsabläufe des Bedienpersonals anpassbar und zudem unabhängiger von Alterungs- und Verschmutzungseffekten ist.

### Darlegung der Erfindung

Diese Aufgabe wird in Verbindung mit den Merkmalen des Oberbegriffs von Anspruch 1 dadurch gelöst, dass weiter ein Differenzierglied umfasst ist, welches ein von einer Reflexionsintensität des reflektierten Sensorstrahlungsanteils abhängiges Sensor-Primärsignal des Reflexionssensors zur Erzeugung eines Sensor-Sekundärsignals einer Differenzierung unterwirft, und die Steuereinheit eingerichtet ist, den motorischen Antrieb in Abhängigkeit vom Vorzeichen des Sensor-Sekundärsignals anzusteuern.

Bevorzugte Ausführungsformen sind Gegenstand der abhängigen Ansprüche.

Die Erfindung bezieht sich in ihrem Kern auf die Nutzung des Signals des im Grunde bekannten Reflexionssensors. Die erfindungsgemäße Ansteuerung macht aus dem vorbekannten Näherungssensor einen Bewegungsrichtungssensor, der in der Lage ist, ein sich näherndes Objekt von einem sich entfernenden Objekt zu unterscheiden. Diese Unterscheidung betrifft nicht nur die Bewegungsrichtung, sondern bis zu einem gewissen Grade auch die Bewegungsgeschwindigkeit. Mathematisch berechnet das Differenzierglied im Wesentlichen die erste zeitliche Ableitung der von dem Reflexionssensor erfassten Reflexionsintensität bzw. eine hierzu funktional äquivalente Größe. Mit anderen Worten wird die zeitliche Änderung der Reflexionsintensität gemessen. Die Erfinder haben erkannt, dass hieraus Rückschlüsse auf die Bewegungsrichtung des Reflexionsobjektes gezogen werden können. Steigt nämlich die Reflexionsintensität an, kann dies theoretisch zwar eine Vielzahl von Gründen, bspw. die Erhöhung der Reflektivität des Reflexionsobjektes zur Ursache haben. Unter den typischen Rahmenbedingungen, unter denen die Pipettenkalibrierung üblicherweise durchgeführt wird, rührt eine Erhöhung der Reflexionsintensität jedoch in der ganz überwiegenden Anzahl der Fälle von einer Verringerung des Abstandes zwischen dem Reflexionsobjekt und dem Reflexionssensor her. Da letzterer gerätefest installiert ist, ist der Schluss zulässig, dass eine Erhöhung der gemessenen Reflexionsintensität mit überwiegender Wahrscheinlichkeit eine Annäherung des Reflexionsobjektes, insbesondere der Pipette bzw. Pipettenspitze, an die Wägevorrichtung repräsentiert. Analoges gilt für die Wegbewegung der Pipette bzw. Pipettenspitze, die mit überwiegender Wahrscheinlichkeit durch ein Absinken der gemessenen Reflexionsintensität repräsentiert wird. Ein Anstieg kann von einem Absinken durch das Vorzeichen der zeitlichen Ableitung der Reflexionsintensität unterschieden werden. Welches Vorzeichen im Einzelfall welcher Bewegungsrichtung zuzuordnen ist, hängt von der speziell realisierten Berechnungsweise der zeitlichen Ableitung ab. Rein mathematisch ist ein Absinken mit einem negativen und ein Ansteigen mit einem positiven Vorzeichen verbunden. Diese Zuordnung soll im Rahmen der weiteren Beschreibung beibehalten werden, wobei der Fachmann erkennen wird, dass auch Berechnungsmethoden mit umgekehrter Vorzeichenzuordnung möglich sind, ohne den Kern der Erfindung zu verändern.

Die Erfindung sieht also zunächst vor, das im Stand der Technik unmittelbar genutzte und von der Reflexionsintensität abhängige Sensor-Primärsignal zu differenzieren. Das differenzierte Sensor-Primärsignal wird hier als Sensor-Sekundärsignal bezeichnet. Weiter sieht die Erfindung vor, die Ansteuerung des Verschlusselementes in Abhängigkeit vom Vorzeichen des Sensor-Sekundärsignals zu gestalten. Insbesondere ist vorgesehen, die Bewegungsrichtung des Verschlusselementes in Abhängigkeit von dem Vorzeichen des Sensor-Sekundärsignals zu gestalten. Noch spezieller ausgedrückt ist vorgesehen, dass Verschlusselement von seiner Verschlussstellung in seine Offenstellung zu überführen, wenn das Sensor-Sekundärsignal das mit einer Annäherung des Reflexionsobjektes an den Reflexionssensor assoziierte Vorzeichen aufweist (und sich das Verschlusselement in seiner Verschlussstellung befindet) und das Verschlusselement von seiner Offenstellung in seine Verschlussstellung zu überführen, wenn das Sensor-Sekundärsignal das mit einer Wegbewegung des Reflexionsobjektes vom Reflexionssensor assoziierte Vorzeichen aufweist (und sich das Verschlusselement in seiner Offenstellung befindet). Dabei ist es möglich und bevorzugt, in die Steuerung eine gewisse Hysterese einzubauen. Dies bedeutet, dass der Bewegungswechsel des Verschlusselementes nicht instantan bei jedem Umschlag des Vorzeichens erfolgt, sondern erst, wenn zugleich ein Mindest-Absolutbetrag des Sensor-Sekundärsignals und/oder des Sensor-Primärsignals vorliegt. Dies verhindert ein "Zittern" des Verschlusselementes auf Grund des Rauschens des Sensors oder der nachgeschalteten Elektronik.

Die vorliegende Erfindung führt gleich zu mehreren Vorteilen. Zum einen wird das Verschlusselement "bedarfsgerecht" gesteuert. Das bedeutet, dass die Zugangsöffnung zum Wägeraum nur dann geöffnet wird, wenn der Benutzer durch Annäherung der Pipette seinen Wunsch signalisiert, mit der Pipette in den Wägeraum einzudringen. Umgekehrt wird die Zugangsöffnung nur dann geschlossen, wenn der Benutzer durch Wegführen der Pipette signalisiert, dass er zumindest in unmittelbarer Zukunft nicht in den Wägeraum eindringen möchte.

Ein weiterer Vorteil der Erfindung ist die Adaptierbarkeit an unterschiedliche Situationen. Insbesondere sind im Empfindlichkeitsbereich des Sensors positionierte, statische oder quasi-statische Objekte, obgleich sie Sensorstrahlung zum Strahlungsempfänger reflektieren, für die Ansteuerung des Verschlusselementes irrelevant, d.h. unschädlich. Statische oder quasi-statische Objekte provozieren nämlich keinen (messungserheblichen) Vorzeichenumschwung des Sensor-Sekundärsignals. Dies gilt sowohl für apparative Elemente, als auch für Körperteile des Benutzers, bspw. ein aus Bequemlichkeitsgründen im Empfindlichkeitsbereich des Sensors abgestützter Arm oder ein nahe an der Wägevorrichtung positioniertes Gesicht. Eine abrupte Änderung der Körperhaltung des Benutzers wird zwar kurzfristig zu einem scheinbar unmotivierten Öffnen oder Schließen des Verschlusselementes führen; nach sehr kurzer Zeit wird der neue Zustand jedoch als "statisch" erkannt werden, sodass nur noch die typischen Hin- und Wegbewegungen der Pipette für das Verschlusselement ansteuerungsrelevant sind.

Ein dritter Vorteil der Erfindung liegt in der Unempfindlichkeit gegenüber Verschmutzungen und Alterungsprozessen. Diese finden typischerweise sehr langsam (im Vergleich zu den Bewegungsgeschwindigkeiten der Pipette) statt. Sie werden somit als quasi-statisch erkannt, d.h. sie führen nicht zu einem relevanten Umschlag des Vorzeichens des Sensor-Sekundärsignals.

Günstigerweise ist der Reflexionssensor als ein digitaler Sensor ausgebildet, mittels dessen ein digitales Sensor-Primärsignal erzeugbar ist. Die Erzeugung eines digitalen Sensor-Primärsignals erleichtert die nachfolgende Signalverarbeitung und -auswertung und ist zudem selbst über weite Kommunikationsstrecken fehlertolerant. Grundsätzlich ist die Erfindung auch mit analogen Sensoren realisierbar.

Es kann vorgesehen sein, dass mittels des Strahlungssenders eine periodisch modulierte Sensor-Strahlung sendbar und dem Strahlungsempfänger ein auf die Modulationsfrequenz der Sensorstrahlung abgestimmter Demodulator zur Erzeugung eines Sensor-Rohsignals nachgeschaltet ist. Mit anderen Worten wird bevorzugt ein Reflexionssensor verwendet, der nach dem sogenannten Chopper-Prinzip arbeitet. Durch das dem Fachmann bekannte Chopper-Prinzip kann das Signal/Rausch-Verhältnis eines Sensors deutlich gesteigert werden. Das derart erzeugte Sensor-Rohsignal kann unmittelbar als Sensor-Primärsignal verwendet werden.

Günstiger erscheint es jedoch, wenn der Reflexionssensor einen ersten Tiefpassfilter aufweist, mittels dessen das Sensor-Rohsignal durch Tiefpassfilterung in das Sensor-Primärsignal umwandelbar ist. Eine derartige Tiefpassfilterung stellt eine effiziente Rauschunterdrückung dar. Der Fachmann wird erkennen, dass eine solche Rauschunterdrückung durch Tiefpassfilterung unabhängig davon günstig ist, ob das Sensor-Rohsignal nach dem Chopper-Prinzip erzeugt wurde oder nicht. Bei nicht gemäß dem Chopper-Prinzip erzeugten Rohsignalen, die typischerweise ein geringeres Signal/Rausch-Verhältnis aufweisen, erscheint die Rauschunterdrückung durch Tiefpassfilterung sogar noch wesentlicher.

Zur konkreten Ausgestaltung des Differenziergliedes stehen dem Fachmann unterschiedliche Möglichkeiten zur Verfügung. Bei einer günstigen Ausgestaltung ist vorgesehen, dass das Differenzierglied einen zweiten Tiefpassfilter umfasst, sowie ein Subtrahierglied, welches einen ungefilterten und einen mittels des zweiten Tiefpassfilters gefilterten Anteil des Sensor-Primärsignals voneinander subtrahiert. Im ungefilterten Signalanteil sind schnelle, zeitliche Änderungen enthalten. Im tiefpassgefilterten Signalanteil sind diese zeitlichen Änderungen eliminiert. Die mittels des Subtrahiergliedes berechnete Differenz beider Signalanteile repräsentiert also im Wesentlichen die schnellen zeitlichen Signaländerungen. Dies entspricht, wie oben erläutert, dem Ziel, mit dem Sensor-Sekundärsignal genau diese zeitlichen Änderungen des Sensor-Primärsignals zu manifestieren. Der Fachmann wird erkennen, dass der Begriff "zweiter Tiefpassfilter" keinesfalls zwingend das Vorhandensein des weiter oben erläuterten "ersten Tiefpassfilters" erfordert. Die Unterscheidung "erster" / "zweiter" erfolgt hier allein zur funktionalen Unterscheidung der alternativ oder gemeinsam einsetzbaren Tiefpassfilter.

Eine alternative Möglichkeit zur Ausgestaltung des Differenziergliedes ist es, wenn ein Verzögerungsglied umfasst ist, sowie ein Subtrahierglied, welches einen unverzögerten und einen mittels des Verzögerungsgliedes verzögerten Anteil des Sensor-Primärsignals voneinander subtrahiert. Ein Verzögerungsglied lässt sich bspw. in Form eines digitalen Schieberegisters realisieren. Bei einem konstanten Signal ist die von dem Subtrahierglied berechnete Differenz zwischen verzögertem und unverzögertem Signalanteil gleich Null. Eine Signaländerung führt zu einer von Null verschiedenen Differenz. Auch hier repräsentiert das erzeugte Sensor-Sekundärsignal die Änderungen im Sensor-Primärsignal.

Wie dem Fachmann bekannt ist, sind am Markt auch integrierte Digital-Differenzierer als eigenständige Bauteile erhältlich. Bei einer Weiterbildung der Erfindung ist daher vorgesehen, einen derartigen integrierten Digital-Differenzierer als erfindungsgemäßes Differenzierglied einzusetzen.

Die vorangehende Beschreibung thematisiert lediglich einen erfindungsgemäß wirkenden Reflexionssensor samt zugeordnetem Differenzierglied. Dies ist jedoch keinesfalls einschränkend auszulegen. Die Verwendung mehrerer Reflexionssensoren ist ebenso möglich und zwar sowohl zur Ansteuerung eines einzigen als auch mehrerer Verschlusselemente, die, z.B. zur Anpassung an rechts- und linkshändische Benutzer, an unterschiedlichen Positionen, insbesondere Seiten, des Schutzgehäuses angeordnet sein können. So kann etwa bei einer Weiterbildung der Erfindung vorgesehen sein, dass mehrere gleichartig wirkende Reflexionssensoren samt zugeordneten Differenziergliedern umfasst sind, die jeweils einem von mehreren motorisch angetriebenen Verschlusselementen zugeordnet sind, wobei die Steuereinheit eingerichtet ist, in Abhängigkeit von dem Signal des das jeweils stärkste Signal liefernden Reflexionssensors den motorischen Antrieb dessen zugeordneten Verschlusselementes anzusteuern. Wird also ein Objekt im Erfassungsraum von mehreren Reflexionssensoren gleichzeitig detektiert und aufgrund der erfindungsgemäßen Signalverarbeitung z.B. als sich nähernd erkannt, kann zur Auswahl, welches der Verschlusselemente sich öffnen soll, die Signalstärke des Sensor-Primärsignals als Entscheidungskriterium herangezogen werden. Dies entspricht einer rudimentären Triangulation. Voraussetzung ist natürlich eine Zuordnung von Verschlusselementen und Reflexionssensoren gemäß der räumlichen Nähe der Verschlusselemente und der Erfassungsbereichen der zugeordneten Reflexionssensoren .

Alternativ ist es auch möglich, mehrere Verschlusselemente mit einem einzigen erfindungsgemäß wirkenden Reflexionssensor mit Differenzierglied zu bedienen, wenn zusätzliche Hilfssensoren eingesetzt werden, die als beliebig ausgebildete Bewegungssensoren, z.B. - jedoch nicht zwingend - ebenfalls als Reflexionssensoren, gestaltet sein können. So ist bei einer Ausführungsform vorgesehen, dass mehrere motorisch angetriebene Verschlusselemente umfasst sind, denen jeweils ein Hilfs-Bewegungssensor zugeordnet ist, mittels dessen ein dem jeweiligen Verschlusselement benachbarter Umgebungsbereich auf Objektbewegungen überwachbar ist, wobei die Steuereinheit weiter eingerichtet ist, in Abhängigkeit von dem Signal des Reflexionssensors jeweils den motorischen Antrieb desjenigen Verschlusselementes anzusteuern, dessen zugeordneter Hilfs-Bewegungssensor zugleich eine Objektbewegung im zugeordneten Umgebungsbereich detektiert. Auch hier ist selbstverständlich eine im Hinblick auf die räumliche Nähe von Verschlusselementen und Hilfs-Bewegungssensoren sinnvolle Zuordnung erforderlich. Der erfindungsgemäß wirkende Reflexionssensor mit Differenzierglied ist dabei für die Detektion der Bewegungsrichtung des Reflexionsobjektes, z.B. der Pipettenspitze, und damit für die Bewegungsrichtung des anzusteuernden Verschlusselementes zuständig; die Hilfs-Bewegungssensoren dienen der Auswahl des anzusteuernden Verschlusselementes.

Sollten sich die Erfassungsbereiche der Hilfs-Bewegungssensoren überlappen, was durchaus der Fall sein kann, um "tote Winkel" zuverlässig zu vermeiden, kann bei einer Weiterbildung dieser Ausführungsform vorgesehen sein, dass die Steuereinheit weiter eingerichtet ist, im Fall, dass mehrere Hilfs-Bewegungssensoren zugleich eine Objektbewegung in ihrem jeweils zugeordneten Umgebungsbereich detektieren, in Abhängigkeit von dem Signal des Reflexionssensors jeweils den motorischen Antrieb desjenigen Verschlusselementes anzusteuern, dessen zugeordneter Hilfs-Bewegungssensor den höchsten Signal-Level liefert. Auch dies entspricht einer rudimentären Triangulation zwischen den Hilfs-Bewegungssensoren.

Selbstverständlich sind auch ausgefeiltere Triangulationsverfahren einsetzbar. Wenn beispielsweise (jedoch nicht nur dann) die Anzahl der Verschlusselemente die Anzahl der (mehreren) Sensoren - seien es mehrere Reflexionssensoren oder mehrere Hilfs-Bewegungssensoren - übersteigt, kann durch einen echten Triangulations-Vergleich der Signalstärken die Richtung bestimmt werden, in der sich das Reflexionsobjekt relativ zur Wägevorrichtung befindet bzw. wo die Objektbewegung stattfindet. Es kann dann dasjenige Verschlusselement zur Ansteuerung ausgewählt werden, dessen Position am besten mit dieser Richtung übereinstimmt. Eine 1:1-Zuordnung von Verschlusselementen und Sensoren ist bei dieser Ausgestaltung nicht erforderlich. In der Praxis wird jedoch aufgrund des hohen mechanischen Aufwandes für eine Vielzahl motorisch angetriebener Verschlusselemente und der Komplexität einer sicheren (echten) Triangulations-Programmierung eine solche Lösung eher selten Einsatz finden. Bei typischen Anwendungen mit zwei Verschlusselementen (z.B. für rechts- und linkshändische Bedienung) dürfte in der Regel eine Realisierung mit rudimentärer Triangulation, wie weiter oben beschrieben, günstiger sein.

Weitere Merkmale und Vorteile der Erfindung ergeben sich aus der nachfolgenden speziellen Beschreibung und den Zeichnungen.

### Kurzbeschreibung der Zeichnungen

Es zeigen:
- Figur 1:: Eine reduzierte Längsschnitt-Darstellung einer Ausführungsform einer erfindungsgemäßen Wägevorrichtung,
- Figur 2:: eine Draufsicht auf die Wägevorrichtung von Figur 1,
- Figur 3:: eine perspektivische Ansicht des Windschutzes der Wägevorrichtung von Figur 1,
- Figur 4:: eine schematische Darstellung einer bevorzugten Wirkungsweise des Reflexionssensors,
- Figur 5:: eine schematische Darstellung einer ersten bevorzugten Form der Erzeugung des Sensor-Sekundärsignals,
- Figur 6:: eine schematische Darstellung einer zweiten bevorzugten Form der Erzeugung des Sensor-Sekundärsignals,

### Ausführliche Beschreibung bevorzugter Ausführungsformen

Gleiche Bezugszeichen in den Figuren deuten auf gleiche oder analoge Elemente hin.

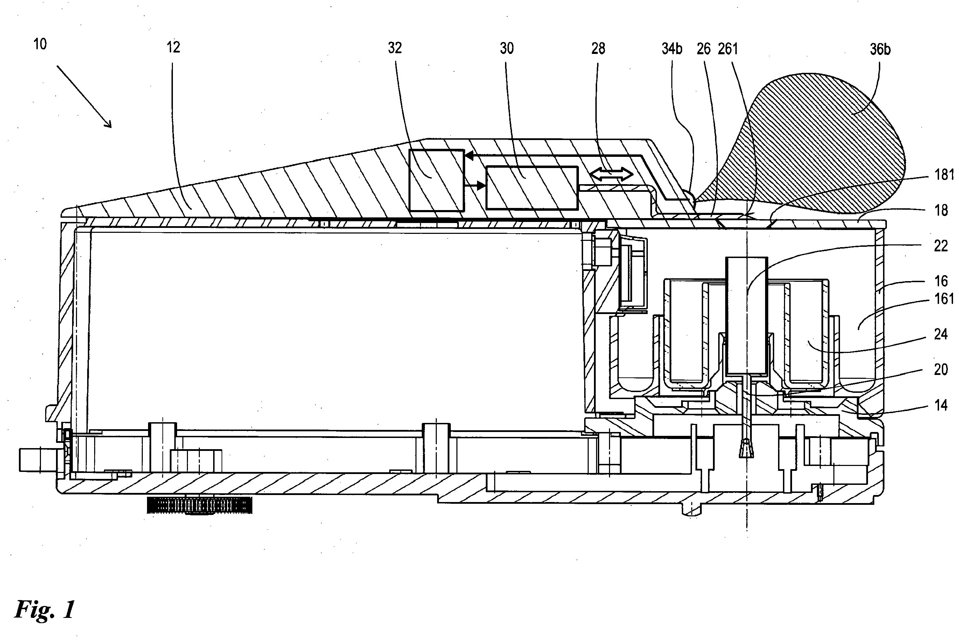

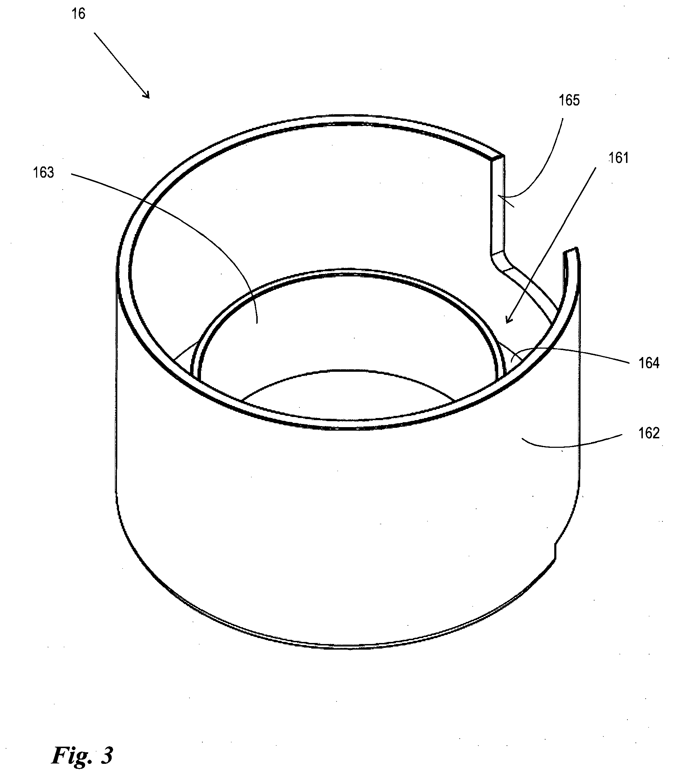

Figur 1 zeigt in einer reduzierten Längsschnitt-Darstellung eine bevorzugte Ausführungsform einer erfindungsgemäßen Wägevorrichtung 10. Die Darstellung ist insofern reduziert, als die für die vorliegende Erfindung irrelevanten Elemente der Wägemechanik und -elektronik nicht dargestellt sind. Die Wägevorrichtung 10 weist ein Gehäuse 12 auf, an dem an seinem vorderen, in Figur 1 rechten Ende eine Arbeitsplattform 14 vorspringt. Auf der Arbeitsplattform 14 ist ein Windschutz 16 aufgesetzt, der in einer besonders bevorzugten Ausführungsform in Figur 3 isoliert dargestellt ist und weiter unten weiter erläutert werden soll. Der Windschutz 16 bildet im Wesentlichen eine umlaufende Wägeraumwandung, die einen innerhalb liegenden Wägeraum seitlich gegen Umwelteinflüsse abschirmt. Der Boden des Wägeraums wird im Wesentlichen durch die Arbeitsplattform 14 gebildet, die in dieser Funktion ebenfalls zur Wägeraumwandung zu rechnen ist. Nach oben hin wird der Wägeraum durch einen Wägeraumdeckel 18 begrenzt, der auf der Oberkannte des Windschutzes 16 aufliegt. Der Wägeraumdeckel 18 schirmt den Wägeraum nach oben gegen Umwelteinflüsse ab und ist insofern ebenfalls zur Wägeraumwandung zu rechnen. Innerhalb des Wägeraums ist eine Wägegutaufnahme 20 angeordnet, die den Wägeraumboden, d.h. die Oberseite der Arbeitsplattform 14 nach unten durchsetzt und in deren Innerem in nicht dargestellter Weise mit der nicht dargestellten Wägemechanik verbunden ist. In Figur 1 sitzt auf der Wägegutaufnahme 20 ein hohlzylindrisches Probengefäß 22 auf.

Das Probengefäß 22 ist von einer ersten Verdunstungsfalle 24 umgeben, die in Form eines konzentrisch um das Probengefäß 22 bzw. die Wägegutaufnahme 20 umlaufenden Ringgefäßes ausgebildet ist. Die erste Verdunstungsfalle 24 dient der Aufnahme einer Flüssigkeit, die während des Betriebs der Wägevorrichtung 10 verdunstet und dadurch die Luftfeuchte im Wägeraum auf einem konstanten, hohen Niveau hält. Die konstant hohe Luftfeuchtigkeit im Wägeraum wirkt einer Verdunstung von Flüssigkeit im Probengefäß 22 entgegen, was insbesondere bei einer Verwendung der Wägevorrichtung 10 als gravimetrische Pipettenkalibrierstation von Bedeutung ist. Die erste Verdunstungsfalle 24 ist vorzugsweise als leicht entnehmbarer Einsatz ausgebildet.

Bei der in Figur 1 gezeigten Ausführungsform ist zusätzlich eine zweite Verdunstungsfalle 161 vorgesehen, die einstückig mit dem Windschutz ausgebildet ist. Wie besonders gut in Zusammenschau der Figuren 1 und 3 erkennbar, ist der Windschutz 16 doppelwandig ausgeführt, wobei eine äußere zylindrische Ringwand 162 und eine innere zylindrische Ringwand 163 durch einen ringförmigen Boden 164 miteinander verbunden sind, sodass ein ringförmiges Gefäß entsteht, welches als zweite Verdunstungsfalle 161, deren Funktionsweise und Wirkung der ersten Verdunstungsfalle 24 entspricht, nutzbar ist. Der Windschutz 16 erfüllt somit eine Doppelfunktion, nämlich als eigentlicher Windschutz und als zweite Verdunstungsfalle. Diese Ausgestaltung, die unabhängig von den übrigen Merkmalen der Erfindung, insbesondere der nachfolgend näher erläuterten Näherungssensorik ist, ist insofern besonders vorteilhaft, als dass dadurch eine Anpassbarkeit an unterschiedliche Probengefäßgrößen gegeben ist. Bei der Kalibrierung unterschiedlich großer Pipetten ist es erforderlich, unterschiedliche Flüssigkeitsmengen pro Kalibrierschritt in das Probengefäß einzufüllen. Für große Probenmengen ist dabei ein großes Probengefäß erforderlich; aus Gründen der Verdunstungsvermeidung ist es für kleine Probenmengen, die grundsätzlich auch in einem großen Probengefäß Platz fänden, günstiger, ein kleines Probengefäß zu verwenden. Zudem spielt die Verdunstung als Störeinfluss bei kleinen Probenmengen eine wesentlich größere Rolle als bei großen Probenmengen. Daher kann, wie beim Aufbau von Figur 1 illustriert, bei kleinen Probengefäßen eine doppelte Verdunstungsfalle genutzt werden, um einer Verdunstung von Probenmaterial besonders wirksam entgegenwirken zu können. Für große Probenmengen kann hingegen die erste Verdunstungsfalle 24 entnommen und das schmale Probengefäß 22 gegen ein Probengefäß größeren Durchmessers, insbesondere eines Durchmessers, der demjenigen der ersten Verdunstungsfalle 24 entspricht, ersetzt werden.

Der Wandungsausschnitt 165 in der äußeren Wandung 162 des Windschutzes 16 dient bei der dargestellten Ausführungsform der formschlüssigen Anpassung des Windschutzes 16 an das Gehäuse 12 der Wägevorrichtung 10. Insgesamt ist der Windschutz 16 bevorzugt als einfach entnehmbarer Einsatz ausgebildet. Dies verbessert insbesondere die Reinigbarkeit der Wägevorrichtung 10. In den Figuren nicht dargestellt ist die vorteilhafte Möglichkeit, den zwischen der äußeren Ringwand 162 und der inneren Ringwand 163 gebildeten Verdunstungsfallenraum durch radiale Trennelemente zu segementieren. Grundsätzlich kann in der Verdunstungsfalle 161 gespeicherte Flüssigkeit bei der Pipettenkalibrierung als Pipettierflüssigkeit verwendet werden. Ein Ein- und Ausführen der Pipette in bzw. aus dem Wägeraum bei jedem Pipettierschritt erübrigt sich dadurch. Durch die erwähnte Segmentierung können unterschiedliche Flüssigkeiten bevorratet werden.

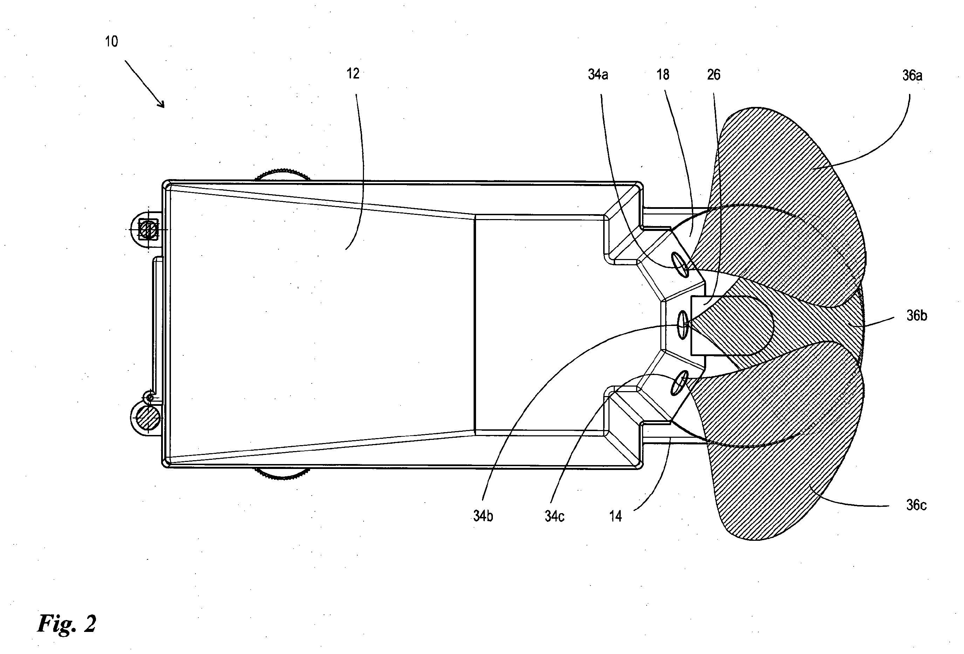

Wie in Figur 1 erkennbar, weist der Wägeraumdeckel 18 einen Zentraldurchbruch 181 auf. Dieser Zentraldurchbruch 181 dient als Zugangsöffnung zum Wägeraum, durch den bei der Pipettenkalibrierung die Pipettenspitze hindurchgeführt werden kann, ohne dass der gesamte Wägeraumdeckel 18 abgenommen werden müsste. Die Zugangsöffnung 181 ist mit einem Verschlusselement 26 verschließbar, welches bei der Ausführungsform von Figur 1 als ein parallel zum Wägeraumdeckel 18 verschiebbarer Schieber ausgebildet ist. Die Verschieblichkeit des Schiebers 26 ist in Figur 1 durch den Verschiebungspfeil 28 angedeutet. Der Schieber 26 ist mit einem nicht im Detail gezeigten Motorantrieb 30 verbunden, der seinerseits signaltechnisch mit einer Steuereinheit 32 gekoppelt ist. Die Steuereinheit 32 ist ihrerseits signaltechnisch mit einer Näherungssensorik 34a, b, c gekoppelt, mit der die Annäherung und Wegbewegung eines (beliebigen) Objektes in einem Erfassungsraum 36a, b, c detektierbar ist. Wie insbesondere in Figur 2 erkennbar, umfasst die Näherungssensorik bei der gezeigten Ausführungsform drei einzelne Reflexionssensoren 34a, 34b, 34c, die jeweils einen Teilraum 36a, 36b, 36c des Erfassungsraumes auf die Präsenz eines Objektes hin überwachen. In einer bevorzugten Ausführungsform sind die Einzelsensoren 34a, 34b, 34c als IR-Reflexionssensoren ausgebildet. Andere Arten von Reflexionssensoren, z.B. Ultraschall-Reflexionssensoren, sind jedoch - unabhängig von der übrigen Gestaltung der Wägevorrichtung 10 - ebenso einsetzbar. Die in den Figuren 1 und 2 angedeuteten, keulenartigen Teilräume, die gemeinsam den Erfassungsraum 36a, b, c der Näherungssensorik 34a, b, c bilden, sind rein illustrativ zu verstehen. Der Fachmann wird erkennen, dass sich bei der IR-Reflexionstechnik ebenso wie bei anderen möglichen Sensortechniken exakt scharfe Erfassungsraumgrenzen nicht werden realisieren lassen. Dieser Erfassungsraum 36a, b, c ist so ausgestaltet, dass er (vom Benutzer aus gesehen) die Zugangsöffnung 181 im Wägeraumdeckel 18 umgibt, sodass keine (hinreichend schnelle) Annäherung an die oder Wegbewegung von der Zugangsöffnung 181 möglich ist, ohne ein Signal der Näherungssensorik 34a, b, c auszulösen. Ein solches Signal wird dann von der Steuereinheit 32 in ein Steuersignal für den motorischen Antrieb 30 des Schiebers 26 übersetzt, sodass sich dieser bei Annäherung eines Objektes an die Zugangsöffnung 181 selbstständig zurückzieht und die Zugangsöffnung 181 freigibt bzw. sich bei Wegbewegung des Objektes selbstständig vorschiebt und die Zugangsöffnung verschließt. Bei einer typischen Pipettenkalibrierung entspricht dieses Objekt der Pipettenspitze.

In Figur 1 erkennbar ist eine nach außen rückspringende Anfasung der vorderen Kante 261 des Schiebers 26. Diese Anfasung führt dazu, dass von dem Volumen des Schiebers 26 bei dessen Vorschub in Verschlussrichtung verdrängte Luft nach außen abgeleitet wird, sodass die Schieberbewegung 28 im Wägeraum selbst keine störenden Luftdruckschwankungen provozieren kann.

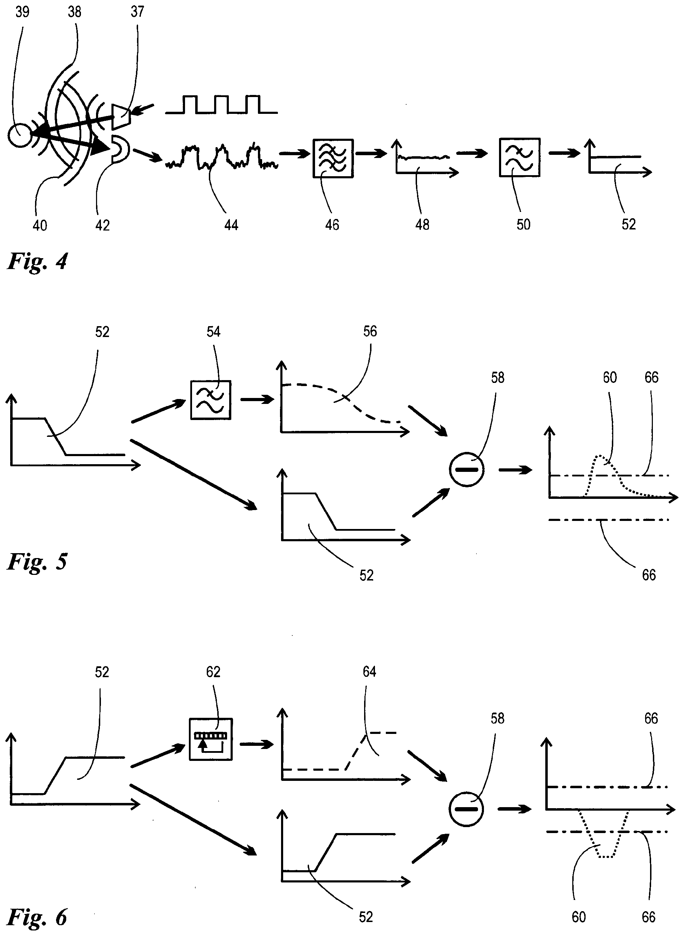

Figur 4 zeigt in stark schematisierter Darstellung eine bevorzugte Ausführungsform der Ansteuerung eines der Reflexionssensoren 34a, 34b, 34c bis zur Erzeugung eines Sensor-Primärsignals 52. Wie bereits erläutert und allgemein bekannt, umfasst ein Reflexionssensor einen Strahlungssender 37, der geeignet und bestimmt ist, eine vorgegebene Strahlungsart, bspw. eine mechanische Welle, wie z.B. Ultraschall oder eine elektromagnetische Welle, wie z.B. IR-Licht, auszusenden. Bei der gezeigten Ausführungsform erfolgt die Sendung der Sensorstrahlung 38 in periodisch modulierter Weise. Die Sensorstrahlung 38 wird an einem im Erfassungsraum 36a, b, c befindlichen Reflexionsobjekt 39, bspw. einer Pipettenspitze, reflektiert. Die reflektierte Sensorstrahlung 40 wird von einem typischerweise in unmittelbarer Nähe zum Strahlungssender 37 positioniertem Strahlungsempfänger 42 detektiert, d.h. in ein Empfänger-Ausgangssignal umgewandelt, dessen Signalstärke typischerweise von der empfangenen Reflexionsintensität abhängig ist. Aufgrund der beim gezeigten Ausführungsbeispiel moduliert ausgesandten Sensorstrahlung 38 resultiert ein entsprechend moduliertes Intensitätssignal 44. Dieses wird einer Demodulation durch einen Demodulator 46, der einen Bandpassfilter umfassen kann, unterzogen, sodass sich ein demoduliertes Signal mit einem guten Signal/Rausch-Verhältnis als Sensor-Rohsignal 48 ergibt. Dieses Sensor-Rohsignal kann unmittelbar als Sensor-Primärsignal verwendet werden. Bei der gezeigten Ausführungsform wird es jedoch noch der Filterung durch einen ersten Tiefpassfilter 50 unterzogen, sodass eine weitere Signalglättung erfolgt, die zu einem sehr rauscharmen Sensor-Primärsignal 52 führt. Der Fachmann wird erkennen, dass die erläuterte Art der Ansteuerung des Reflexionssensors nach dem sogenannten "Chopper-Prinzip" zu einer Verbesserung der Signalqualität des Sensor-Primärsignals 52 führt, für dessen Erzeugung jedoch keineswegs erforderlich ist. Insbesondere ist alternativ auch eine unmodulierte Ansteuerung des Strahlungssenders 37 denkbar.

Die Figuren 5 und 6 zeigen zwei Varianten zur erfindungsgemäßen Weiterverarbeitung des vorzugsweise, aber keinesfalls zwingend gemäß dem Prinzip von Figur 4 erzeugten Sensor-Primärsignals 52. In jedem Fall wird das Sensor-Primärsignal 52 einer Differenzierung unterzogen. Bei der Ausführungsform von Figur 5 erfolgt die Differenzierung durch Tiefpassfilterung und Subtraktion. Bei der Ausführungsform von Figur 6 erfolgt die Differenzierung durch Verzögerung und Subtraktion.

Bei der Ausführungsform gemäß Figur 5 wird das Sensor-Primärsignal 52 teilweise der Filterung durch einen Tiefpassfilter 54 unterzogen. Es resultiert ein gefiltertes Sensor-Primärsignal 56. Von diesem wird der ungefilterte Anteil des Sensor-Primärsignals 52 mittels des Subtrahiergliedes 58 subtrahiert. Es resultiert ein Sensor-Sekundärsignal 60, welches im Wesentlichen der ersten zeitlichen Ableitung des Sensor-Primärsignals entspricht. Bei dem in Figur 5 gezeigten Beispiel repräsentiert das Sensor-Primärsignal 52 einen Intensitätsabfall, wie er insbesondere durch eine Wegbewegung des Reflexionsobjektes 39 vom Reflexionssensor erfolgen kann. Es resultiert ein Sensor-Sekundärsignal 60, welches für die Zeiten konstanten Sensor-Primärsignals 52 einen Wert von Null und während der Änderung des Sensor-Primärsignal 52 einen Wert größer Null aufweist. Das positive Vorzeichen deutet hier also auf eine Wegbewegung des Reflexionsobjektes 39 hin, die zum Anlass genommen werden kann, das Verschlusselement von seiner Offen- in seine Verschlussstellung zu überführen.

Figur 6 zeigt den umgekehrten Fall eines ansteigenden Sensor-Primärsignal 52, was auf eine Annäherungsbewegung des Reflexionsobjektes 39 schließen lässt. Entsprechend resultiert eine negatives Sensor-Sekundärsignal 60, sodass das negative Vorzeichen des Sensor-Sekundärsignals mit der Annäherungsbewegung des Reflexionsobjektes 39 assoziiert werden kann. Hinsichtlich des speziellen Berechnugsmechanismus unterscheidet sich die Ausführungsform von Figur 6 von derjenigen der Figur 5 dadurch, dass ein Signalanteil des Sensor-Primärsignals 52 keiner Tiefpass-Filterung, sondern einer Verzögerung durch ein Verzögerungsglied 62, das bspw. als Schieberegister sein kann, unterzogen wird. Es resultiert ein verzögertes Sensor-Primärsignal 64, von welchem, vergleichbar zu dem Fall von Figur 5, das unverzögerte Sensor-Primärsignal 52 mittels des Subtrahiergliedes 58 subtrahiert wird.

Bei den Ausführungsformen der Figuren 5 und 6 sind Schwellenwerte 66 eingezeichnet, die bevorzugt von dem Sensor-Sekundärsignal 60 zu überwinden sind, um eine Ansteuerung des Verschlusselementes auszulösen. Hierdurch wird eine Hysterese in der Bewegung des Verschlusselementes realisiert, die ein Zittern des Verschlusselementes bei verrauschtem Sensor-Sekundärsignal 60 verhindert. Auch kann auf diese Weise sichergestellt werden, dass nur hinreichend schnelle Bewegungen des Reflexionsobjektes 39 zu einer Ansteuerung des Verschlusselementes führen. Langsame Bewegungen, deren Geschwindigkeit deutlich unter der typischen Bewegungsgeschwindigkeit bei der Pipettenkalibrierung liegt, werden von dem System als statisch oder quasi-statisch eingestuft und führen zu keinen unerwünschten Verschlusselement-Aktionen.

Natürlich stellen die in der speziellen Beschreibung diskutierten und in den Figuren gezeigten Ausführungsformen nur illustrative Ausführungsbeispiele der vorliegenden Erfindung dar. Dem Fachmann ist im Lichte der hiesigen Offenbarung ein breites Spektrum von Variationsmöglichkeiten an die Hand gegeben. Insbesondere ist die Erfindung nicht auf eine spezielle Sensortechnik oder eine spezielle Anzahl von Einzelsensoren beschränkt. Auch ist es für die Erfindung nicht zwingend erforderlich, dass sich die Zugangsöffnung 182 im Wägeraumdeckel 18 befindet. Beispielsweise sind auch Ausführungsformen mit seitlich angeordneter Zugangsöffnung denkbar.

### Bezugszeichenliste

- 10: Wägevorrichtung
- 12: Gehäuse
- 14: Arbeitsplattform
- 16: Windschutz
- 161: Zweite Verdunstungsfalle
- 162: Äußere Ringwand von 16
- 163: Innere Ringwand von 16
- 164: Boden zwischen 162 und 163
- 165: Ausschnitt in 162
- 18: Wägeraumdeckel
- 181: Zugangsöffnung in 18
- 20: Wägegutaufnahme
- 22: Probengefäß
- 24: Erste Verdunstungsfalle
- 26: Verschlusselement
- 28: Verschiebepfeil
- 30: Motorischer Antrieb
- 32: Steuereinheit
- 34a, b, c: Reflexionssensor
- 36a, b, c: Erfassungsraum
- 37: Strahlungssender
- 38: Sensorstrahlung
- 39: Reflexionsobjekt
- 40: reflektierte Sensorstrahlung
- 42: Strahlungsempfänger
- 44: moduliertes Intensitätssignal
- 46: Demodulator
- 48: Sensor-Rohsignal
- 50: erster Tiefpassfilter
- 52: Sensor-Primärsignal
- 54: zweiter Tiefpassfilter
- 56: gefiltertes Sensor-Primärsignal
- 58: Subtrahierglied
- 60: Sensor-Sekundärsignal
- 62: Verzögerungsglied
- 64: verzögertes Sensor-Primärsignal
- 66: Schwellenwert

## Patentansprüche

1. Wägevorrichtung, umfassend
- eine Wägegutaufnahme (20),
- ein die Wägegutaufnahme (20) umgebendes Schutzgehäuse (14,16,18) mit einer Zugangsöffnung (181) und einem die Zugangsöffnung (181) in seiner Verschlussstellung verschließenden und sie in seiner Offenstellung freigebenden Verschlusselement (26),
- einen Reflexionssensor (34a, b, c) mit einem Strahlungssender (37) zur Aussendung einer von einem Reflexionsobjekt (39) reflektierbaren Sensorstrahlung (38) und mit einem Strahlungsempfänger (42) zum Empfangen eines von dem Reflexionsobjekt (39) reflektierten Sensorstrahlungsanteils (40) und
- eine mit einem motorischen Antrieb (30) des Verschlusselementes (26) und mit dem Reflexionassensor (34a, b, c) verbundene Steuereinheit (32), die eingerichtet ist, den motorischen Antrieb (30) in Abhängigkeit von einem Signal des Reflexionssensors (34a, b, c) bei Annäherung des Reflexionsobjektes (39) zur Überführung des Verschlusselementes (26) von seiner Verschluss- in seine Offenstellung und bei Wegbewegung des Reflexionsobjektes (39) zur Überführung des Verschlusselementes (26) von seiner Offen- in seine Verschlussstellung anzusteuern,
**dadurch gekennzeichnet,**
**dass** weiter ein Differenzlerglied umfasst ist, welches ein von einer Reflexionsintensität des reflektierten Sansorstrahlungsanteils (40) abhängiges Sensor-Primärslgnal (52) des Reflexionssensors (34a, b, c) zur Erzeugung eines Sensor-Sekundärsignals (60) einer Differenzierung unterwirft, und die Steuereinheit (32) eingerichtet ist, den motorischen Antrieb (30) In Bezug auf die Bewegungsrichtung des Vorschlussolementes in Abhängigkeit von dem jeweils mit einer Bewegungsrichtung des Reflexionsobjektes (39) assoziierten Vorzeichen des Sensor-Sekundärsignals (60) anzusteuern.

2. Wägevorrichtung nach Anspruch 1,
**dadurch gekennzeichnet,**
**dass** der Reflexionssensor (34a, b, c) als ein digitaler Sensor ausgebildet ist, mittels dessen ein digitales Sensor-Primärsignal (52) erzeugbar ist.

3. Wägevorrichtung nach einem der vorangehenden Ansprüche,
**dadurch gekennzeichnet,**
**dass** mittels des Strahlungssenders (37) eine periodisch modulierte Sensorstrahlung (38) sendbar und dem Strahlungsempfänger (42) ein auf die Modulationsfrequenz der Sensorstrahlung (38) abgestimmter Demodulator (46) zur Erzeugung eines Sensor-Rohsignal (48) nachgeschaltet ist.

4. Wägevorrichtung nach einem der vorangehenden Ansprüche,
**dadurch gekennzeichnet,**
**dass** der Reflexionssensor (34a, b, c) einen ersten Tiefpassfilter (50) aufwelst, mittels dessen das Sensor-Rohsignal (48) durch Tiefpassfilterung in das Sensor-Primärsignal (52) umwandelbar ist.

5. Wägevorrichtung nach einem der vorangehenden Ansprüche,
**dadurch gekennzeichnet,**
**dass** das Differenzierglied einen zweiten Tiefpassfilter (54) umfasst sowie ein Subtrahierglied (58), welches einen ungefilterten und einen mittels des zweiten Tiefpassfilters (54) gefilterten Anteil des Sensor-Primärsignals voneinander subtrahiert.

6. Wägevorrichtung nach Anspruch 1 bis 4,
**dadurch gekennzeichnet,**
**dass** das Differenzierglied ein Verzögerungsglied (62) umfasst sowie ein Subtrahierglied (58), welches einen unverzögerten und einen mittels des Verzögerungsgiledes (62) verzögerten Anteil des Sensor-Primärsignals voneinander subtrahiert.

7. Wägevorrichtung nach Anspruch 2 oder einem der Ansprüche 3 bis 4, soweit auf Anspruch 2 rückbezogen,
**dadurch gekennzeichnet,**
**dass** das Differenzierglied als ein integrierter Digital-Differenzlerer ausgebildet ist.

8. Wägevorrichtung nach einem der vorangehenden Ansprüche,
**dadurch gekennzeichnet.**
**dass** mehrere motorisch angetriebene Verschlusselemente und mehrerer gleichwirkende Reflexionssensoren samt zugeordneten Differenziergliedem umfasst sind, wobei die Steuereinheit weiter eingerichtet ist, jeweils den motorischen Antrieb desjenigen Verschlusselementes anzusteuern, dessen Position am besten mit einer Richtung übereinstimmt, in der sich gemäß einem Triangulations-Vergleich der Signalstärken der Sensor-Primärsignale der Reflexionssensoren das Reflexionsobjekt befindet.

9. Wägevorrichtung nach Anspruch 8,
**dadurch gekennzeichnet,**
**dass** den Reflexionssensoren jeweils eines der Verschlusselemente zugeordnet ist, wobei die Steuereinheit eingerichtet ist, jeweils den motorischen Antrieb desjenigen Verschlusselementes anzusteuern, dessen zugeordneter Reflexionssensor das stärkste Sensor-Primärsignal liefert.

10. Wägevorrichtung nach einem der Ansprüche 1 bis 7,
**dadurch gekennzeichnet,**
**dass** mehrere motorisch angetriebene Verschlusselemente und mehrere Hilfs-Bewegungssensoren, mittels derer ein Umgebungsbereich der Verschlusselemente auf Objektbewegungen überwachbar ist, vorhanden sind, wobei die Steuereinheit weiter eingerichtet ist, in Abhängigkeit von dem Signal des Reflexionssensors jeweils den motorischen Antrieb desjenigen Verschlusselementes anzusteuem, dessen Position am besten mit einer Richtung übereinstimmt, in der gemäß einem Triangulations-Vergieich der Signal-Level der Hilfs-Bewegungssensoren eine Objektbewegung stattfindet.

11. Wägevorrichtung nach Anspruch 10,
**dadurch gekennzeichnet,**
**dass** den Hilfs-Bewegungssensoren jeweils eines der Verschlusselemente zugeordnet ist, wobei die Steuereinheit weiter eingerichtet ist, jeweils den motorischen Antrieb desjenigen Verschlusselementes anzusteuern, dessen zugeordneter Hilfs-Bewegungssensor eine Objektbewegung im zugeordneten Umgebungsbereich detektiert

12. Wägevorrichtung nach Anspruch 11,
**dadurch gekennzeichnet,**
**dass** die Steuereinheit weiter eingerichtet ist, im Fall, dass mehrere Hilfs-Bewegungssensoren zugleich eine Objektbewegung in Ihrem Jeweils zugeordneten Umgebungsbereich detektieren, In Abhängigkeit von dem Signal des Reflexionssensors jeweils den motorischen Antrieb desjenigen Verschlusselementes anzusteuern, dessen zugeordneter Hilfs-Bewegungssensor den höchsten Signal-Level liefert.

## Claims

1. A weighing device, comprising
- a receptacle for the goods to be weighed (20),
- a protective housing (14, 16, 18) enclosing the receptacle for the goods to be weighed (20), an access opening (181) and a closure element (26) closing the access opening (181) in its closed position and releasing it in its opened position,
- a reflection sensor (34a, b, c) with a radiation transmitter (37) for emitting a sensor radiation (38) that can be reflected from a reflection object (39) and with a radiation receiver (42) for receiving a sensor radiation portion (40) reflected from the reflection object (39) and
- a control unit (32) connected to a motorized drive (30) of the closure element (26) and to the reflection sensor (34a, b, c), which is equipped to control the motorized drive (30) depending on a signal of the reflection sensor (34a, b, c) upon approach of the reflection object (39) for transferring the closure element (26) from its closed to its opened position and upon movement of the reflection object (26) away for transferring the closure element (26) from its open to its closed position,
**characterized in**
**that** further, a differentiation element is comprised, which subjects a sensor primary signal (52) of the reflection sensor (34a, b, c) to a differentiation dependent on a reflection intensity of the reflected sensor radiation portion (40) for the generation of a sensor secondary signal (60), and the control unit (32) is equipped to control the motorized drive (30) in relation to the movement direction of the closure element in dependence on the respective sign of the sensor secondary signal (60) associated with a movement direction of the reflection object (39).

2. The weighing device according to Claim 1,
**characterized in**
**that** the reflection sensor (34a, b, c) is designed as a digital sensor, by means of which a digital sensor primary signal (52) can be generated.

3. The weighing device according to any of the preceding claims,
**characterized in**
**that** by means of the radiation transmitter (37) a periodically modulated sensor radiation (38) can be transmitted and a demodulator (46) tuned to the modulation frequency of the sensor radiation (38) for the generation of a sensor raw signal (48) is downstream of the radiation receiver (42) .

4. The weighing device according to any of the preceding claims,
**characterized in**
**that** the reflection sensor (34a, b, c) has a first low pass filter (50), by means of which the sensor raw signal (48) can be converted to the sensor primary signal (52) by means of low pass filtering.

5. The weighing device according to any of the preceding claims,
**characterized in**
**that** the differential element comprises a second low pass filter (54) and a subtraction element (58) which subtracts an unfiltered portion of the sensor primary signal and a filtered portion by means of the second low pass filter (54) from each other.

6. The weighing device according to Claim 1 to 4,
**characterized in**
**that** the differential element comprises a delay element (62) and a subtraction element (58), which subtracts an undelayed portion of the sensor primary signal and a delayed portion by means of the delay element (62) from each other.

7. The weighing device according to Claim 2 or any of claims 3 to 4, if they refer back to Claim 2,
**characterized in**
**that** the differential element is designed as an integrated digital differentiator.

8. The weighing device according to any of the preceding claims,
**characterized in**
**that** several motor-driven closure elements and several equally acting reflection sensors together with their assigned differential elements are comprised, wherein the control unit is further set up in each case to control the motorized drive of the closure element whose position best matches a direction in which, in accordance with a triangulation comparison of the signal strengths of the sensor primary signals of the reflection sensors of the reflection object are located.

9. The weighing device according to Claim 8,
**characterized in**
**that**, in each case one of the closure elements is assigned to the reflection sensors, wherein the control unit is equipped, in each case, to control the motorized drive of the closure element whose assigned reflection sensor returns the strongest sensor primary signal.

10. The weighing device of any of Claims 1 to 7,
**characterized in**
**that** several motor driven closure elements and several auxiliary motion sensors are present, by means of which a surrounding area of the closure elements can be monitored for object movements, wherein the control unit is further equipped, depending on the signal of the reflection sensor, in each case to control the motorized drive of the closure element whose position best matches a direction in which, according to a triangulation comparison of the signal level of the auxiliary motion sensor, an object movement takes place.

11. The weighing device according to Claim 10,
**characterized in**
**that**, in each case one of the closure elements is assigned to the auxiliary motion sensor, wherein the control unit is further equipped, in each case to control the motorized drive of the closure element whose assigned auxiliary movement sensor detects an object movement in the assigned surrounding area.

12. The weighing device according to Claim 11,
**characterized in**
**that** the control unit is further equipped, in the case that several auxiliary movement sensors simultaneously detect an object movement in their respective assigned surrounding area, depending on the signal of the reflection sensor, in each case to control the motorized drive of the closure element whose assigned auxiliary movement sensor returns the highest signal level.

## Revendications

1. Dispositif de pesée, comprenant
- un logement de produit à peser (20),
- un boîtier de protection (14, 16, 18) entourant le logement de produit à peser (20), avec une ouverture d'accès (181) et un élément de fermeture (26) fermant l'ouverture d'accès (181) dans sa position de fermeture et la libérant dans sa position d'ouverture,
- un capteur de réflexion (34a, b, c) avec un émetteur de rayonnement (37) destiné à émettre un rayonnement de capteur (38) pouvant être réfléchi par un objet de réflexion (39) et avec un récepteur de rayonnement (42) destiné à recevoir une fraction de rayonnement de capteur (40) réfléchie par l'objet de réflexion (39) et
- une unité de commande (32) reliée à un entraînement motorisé (30) de l'élément de fermeture (26) et au capteur de réflexion (34a, b, c), qui est conçue pour commander l'entraînement motorisé (30) en fonction d'un signal du capteur de réflexion (34a, b, c) lors d'un rapprochement de l'objet de réflexion (39) pour amener l'élément de fermeture (26) de sa position de fermeture à sa position d'ouverture et lors de l'éloignement de l'objet de réflexion (39) pour amener l'élément de fermeture (26) de sa position d'ouverture à sa position de fermeture,
**caractérisé en ce**
**qu'**un organe de différenciation est en outre compris, lequel soumet un signal primaire de capteur (52) du capteur de réflexion (34a, b, c) dépendant d'une intensité de réflexion de la fraction de rayonnement de capteur (40) réfléchie, pour produire un signal secondaire de capteur (60), à une différenciation, et l'unité de commande (32) est conçue pour commander l'entraînement motorisé (30) par rapport à la direction de mouvement de l'élément de fermeture en fonction du signe, associé respectivement à une direction de mouvement de l'objet de réflexion (39), du signal secondaire de capteur (60) .

2. Dispositif de pesée selon la revendication 1,
**caractérisé en ce**
**que** le capteur de réflexion (34a, b, c) est réalisé sous la forme d'un capteur numérique, au moyen duquel un signal primaire de capteur (52) numérique peut être produit.

3. Dispositif de pesée selon l'une quelconque des revendications précédentes,
**caractérisé en ce**
**qu'**un rayonnement de capteur (38) modulé périodiquement peut être émis au moyen de l'émetteur de rayonnement (37) et un démodulateur (46) accordé sur la fréquence de modulation du rayonnement de capteur (38) et destiné à produire un signal brut de capteur (48) est situé en aval du récepteur de rayonnement (42).

4. Dispositif de pesée selon l'une quelconque des revendications précédentes,
**caractérisé en ce**
**que** le capteur de réflexion (34a, b, c) présente un premier filtre passe-bas (50), au moyen duquel le signal brut de capteur (48) peut être converti en signal primaire de capteur (52) par filtrage passe-bas.

5. Dispositif de pesée selon l'une quelconque des revendications précédentes,
**caractérisé en ce**
**que** l'organe de différenciation comprend un deuxième filtre passe-bas (54) ainsi qu'un organe de soustraction (58), lequel soustrait une fraction du signal primaire de capteur non filtrée et une filtrée au moyen du deuxième filtre passe-bas (54) l'une de l'autre.

6. Dispositif de pesée selon les revendications 1 à 4,
**caractérisé en ce**
**que** l'organe de différenciation comprend également un organe de retard (62) ainsi qu'un organe de soustraction (58), lequel soustrait une fraction non retardée du signal primaire de capteur et une retardée au moyen de l'organe de retard (62) l'une de l'autre.

7. Dispositif de pesée selon la revendication 2 ou l'une des revendications 3 à 4, dans la mesure où elle est rattachée à la revendication 2,
**caractérisé en ce**
**que** l'organe de différenciation est réalisé sous la forme d'un différentiateur numérique intégré.

8. Dispositif de pesée selon l'une quelconque des revendications précédentes,
**caractérisé en ce**
**que** plusieurs éléments de fermeture entraînés de façon motorisée et plusieurs capteurs de réflexion d'action équivalente y compris les organes de différenciation associés sont compris, dans lequel l'unité de commande est conçue en outre pour commander respectivement l'entraînement motorisé de l'élément de fermeture dont la position concorde le mieux avec une direction dans laquelle l'objet de réflexion se trouve selon une comparaison de triangulation des intensités de signal des signaux primaires de capteur des capteurs de réflexion.

9. Dispositif de pesée selon la revendication 8,
**caractérisé en ce**
**que** respectivement un des éléments de fermeture est associé aux capteurs de réflexion, dans lequel l'unité de commande est conçue pour commander respectivement l'entraînement motorisé de l'élément de fermeture dont le capteur de réflexion associé délivre le signal primaire de capteur le plus intense.

10. Dispositif de pesée selon l'une quelconque des revendications 1 à 7,
**caractérisé en ce**
**que** plusieurs éléments de fermeture entraînés de façon motorisée et plusieurs capteurs de mouvement auxiliaires, au moyen desquels une zone environnante des éléments de fermeture peut être surveillée à la recherche de mouvements d'objet, sont présents, dans lequel l'unité de commande est conçue en outre pour commander, en fonction du signal du capteur de réflexion, respectivement l'entraînement motorisé de l'élément de fermeture dont la position concorde le mieux avec une direction dans laquelle un mouvement d'objet a lieu selon une comparaison de triangulation des niveaux de signal des capteurs de mouvement auxiliaires.

11. Dispositif de pesée selon la revendication 10,
**caractérisé en ce**
**que** respectivement un des éléments de fermeture est associé aux capteurs de mouvement auxiliaires, dans lequel l'unité de commande est conçue en outre pour commander respectivement l'entraînement motorisé de l'élément de fermeture dont le capteur de mouvement auxiliaire associé détecte un mouvement d'objet dans la zone ambiante associée.

12. Dispositif de pesée selon la revendication 11,
**caractérisé en ce**
**que** l'unité de commande est conçue en outre, au cas où plusieurs capteurs de mouvement auxiliaires détecteraient en même temps un mouvement d'objet dans leur zone environnante respectivement associée, pour commander, en fonction du signal du capteur de réflexion, respectivement l'entraînement motorisé de l'élément de fermeture dont le capteur de mouvement auxiliaire associé délivre le niveau de signal le plus élevé.
